# EUROPEAN PATENT APPLICATION

(11) **EP 2 040 315 A2**
(43) Date of publication of application: **25.03.2009**
(21) Application number: 08016447.8
(22) Date of filing: 18.09.2008
(51) Int. Cl.: H01L 51/52

(54) **Environment-sensitive device, and method for sealing environment-sensitive element**

(30) Priority: 19.09.2007 JP 2007241967
(71) Applicant: Fujifilm Corporation, Tokyo 106-0031 (JP)
(72) Inventor: Tsukahara, Jiro, Ashigarakami-gun Kanagawa 258-8577 (JP); Ito, Shigehide, Ashigarakami-gun Kanagawa 258-8577 (JP); Senga, Takeshi, Kanagawa 250-0193 (JP)
(74) Representative: HOFFMANN EITLE

(57) **Abstract**

A device comprising an environment-sensitive element (2) and a barrier laminate (3) in that order on a substrate (1), wherein the barrier laminate comprises at least one silicon hydronitride layer and at least one other inorganic layer. The device is highly resistant to deterioration by water vapor.

## Description

### TECHNICAL FIELD

The present invention relates to an environment-sensitive device, a method for sealing an environment-sensitive element, and a method for producing an environment-sensitive element.

### BACKGROUND ART

Heretofore investigated is providing a gas-barrier film and a protective layer in an environment-sensitive element. USP 6268695 describes an environment-sensitive device in which the surface of the environment-sensitive element provided on a substrate is sealed with an organic/inorganic laminate. JP-A 2007-184251 descries providing a protective layer (passivation layer) on the surface of a light-emitting element provided on a substrate. In this, a silicon nitride layer is used as the protective layer.

### SUMMARY OF THE INVENTION

However, in an environment-sensitive device, for example, in an organic EL device (organic electroluminescent device ), the light-emitting material and the electrode material are often deteriorated by water, and therefore, a sealing technique of protecting the material from moisture (e.g., water vapor) penetration thereinto and a moisture-absorbing technique of absorbing the moisture having penetrated into the material are significant subjects for practical use of the devices. In a conventional sealing technique (so-called canning or bottling) of sealing an environment-sensitive element in a stainless can or a glass bottle, a desiccant such as calcium oxide may put in the free space inside the can or bottle to thereby solve the two problems of sealing and moisture absorption. However, according to a method of directly sticking a glass sheet or a gas-barrier film to a device (so-called solid sealing) or according to a method of directly disposing a gas-barrier film on a device (so-called film sealing), the device could not have a free space around it, and therefore a desiccant could not be introduced into the sealed device. This case is problematic in that the element may be deteriorated by the moisture initially existing inside the element or by the moisture penetrating into the element not via the sealing material (for example, the water vapor penetrating into the element through its edge or via the adhesive used). The deterioration by such moisture shortens the life of the element.

The present invention is to solve these problems, and to prevent deterioration by water vapor.

Given that situation, the present inventors have assiduously studied and, as a result, have found that, in an environment-sensitive device, when the environment-sensitive element provided on a substrate is sealed with a barrier laminate comprising a silicon hydronitride layer and any other inorganic layer, then the silicon hydronitride layer in the environment-sensitive device can substantially play a role of desiccant and can prevent the environment-sensitive device from being deteriorated by moisture, and have completed the present invention. In particular, the present invention is characterized in that, in film sealing not having a free space around the sealed device, it may attain the capability substantially equal to that attainable by desiccant addition.

Concretely, the invention includes the following constitutions:
(1) An environment-sensitive device comprising an environment-sensitive element and a barrier laminate in that order on a substrate, wherein the barrier laminate comprises at least one silicon hydronitride layer and at least one other inorganic layer.
(2) The environment-sensitive device according to (1), wherein the barrier laminate further comprises at least one organic layer.
(3) The environment-sensitive device according to (2), wherein at least one of the organic layer comprises an acrylate polymer as the main ingredient thereof.
(4) The environment-sensitive device according to any one of (1) to (3), wherein at least one of the other inorganic layer is a passivation layer.
(5) The environment-sensitive device according to any one of (1) to (4), wherein at least one of the other inorganic layer is a silicon nitride layer.
(6) The environment-sensitive device according to (5), wherein the silicon nitride layer is provided on the side of the environment-sensitive element of the silicon hydronitride layer.
(7) The environment-sensitive device according to (5) or (6), wherein the silicon nitride layer is formed by a PECVD method.
(8) The environment-sensitive device according to any one of (1) to (7), wherein the hydrogen/nitrogen ratio in the silicon hydronitride layer is from 1 to 3.
(9) The environment-sensitive device according to any one of (1) to (8), wherein the silicon hydronitride layer has a film density of from 1.8 to 2.0 g/cm³.
(10) The environment-sensitive device according to any one of (1) to (9), wherein the silicon hydronitride layer is formed by a PECVD method.
(11) The environment-sensitive device according to any one of (1) to (10), wherein the substrate is a flexible substrate.
(12) The environment-sensitive device according to any one of (1) to (11), wherein at least one of the other inorganic layer comprises aluminium oxide as the main ingredient thereof.
(13) The environment-sensitive device according to any one of (1) to (12), wherein the substrate is a gas-barrier film.
(14) The environment-sensitive device according to any one of (1) to (13), wherein the environment-sensitive element is sealed with a gas-barrier film.
(15) The environment-sensitive device according to any one of (1) to (14), which is an organic EL device.
(16) A method of sealing an environment-sensitive element, which comprises providing a barrier laminate comprising at least one silicon hydronitride layer and at least one other inorganic layer, on the environment-sensitive element provided on a substrate.
(17) A method for producing an environment-sensitive device, which comprises providing a barrier laminate comprising at least one silicon hydronitride layer and at least one other inorganic layer, on an environment-sensitive element provided on a substrate.

The present invention has made it possible to protect an environment-sensitive device, especially even a solid-sealed or film-sealed environment-sensitive device not having a free space around the device, from deterioration by water vapor, thereby prolonging the device life, and for example, to prevent an organic EL device from having dark spots therein.

### BRIEF DESCRIPTION OF DRAWINGS

Fig. 1 is an outline view showing one embodiment of the environment-sensitive device of the invention.
Fig. 2 is an outline view illustrating one example of a more concrete constitution of the environment-sensitive device of the invention.
Fig. 3 is an outline view illustrating another example of a more concrete constitution of the environment-sensitive device of the invention.

In the drawings, 1 is substrate, 2 is environment-sensitive element, 3 is gas-barrier laminate, 301 is passivation layer, 302 is silicon hydronitride layer, 303 is organic/inorganic laminate, 311 is passivation layer, and 313 is organic/inorganic laminate.

### DETAILED DESCRIPTION OF THE INVENTION

The contents of the invention are described in detail hereinunder. In this description, the numerical range expressed by the wording "a number to another number" means the range that falls between the former number indicating the lowermost limit of the range and the latter number indicating the uppermost limit thereof. The organic EL device as referred to herein means an organic electroluminescent device. Unless otherwise specifically indicated, the main ingredient as referred to herein means the principal ingredient of the layer, the substance or the like, and for example, it is the ingredient of which the content (ratio by weight) is the largest.

### «Constitution of Environment-Sensitive Device»

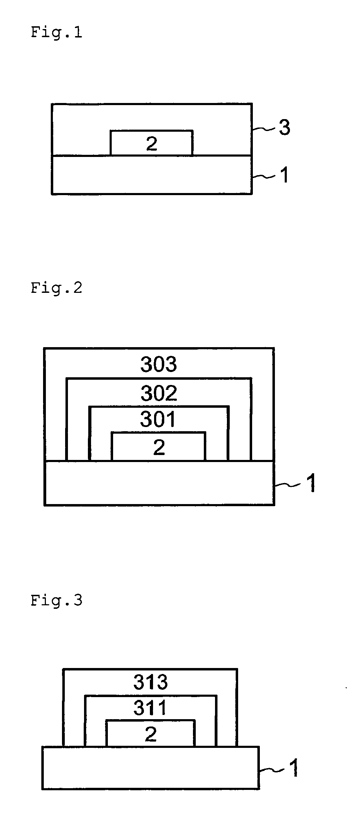

The environment-sensitive device of the invention is characterized by comprising, as provided on the substrate thereof, an environment-sensitive element and a barrier laminate that comprises a silicon hydronitride layer and some other inorganic layer. One preferred embodiment of the environment-sensitive device of the invention is described with reference to Fig. 1. Needless-to-say, the environment-sensitive device of the invention should not be limited to it. In Fig. 1, 1 is a substrate, 2 is an environment-sensitive element, and 3 is a gas-barrier laminate comprising a silicon hydronitride layer and some other inorganic layer. Any additional layer, substrate and the like may be laminated on 3.

In this, the environment-sensitive element means an element comprising a pair of electrodes and an organic compound layer provided therebetween in an organic EL device, and is a part that has the substantial function of an environment-sensitive device. In general, the environment-sensitive element 2 is provided on the substrate 1 (the part including the substrate may be referred to as an environment-sensitive element).

In Fig. 1, the gas-barrier laminate 3 preferably has an organic layer, along with the silicon hydronitride layer and the other inorganic layer. The silicon hydronitride layer, the other inorganic layer and the organic layer may have a silicon hydronitride region, some other inorganic region and an organic region, respectively, of grated materials not having any definite boundary between them.

Fig. 2 illustrates more concretely the environment-sensitive device of the invention. In Fig. 2, 301 is another inorganic layer playing a role of a passivation layer. 302 is a silicon hydronitride layer; and 303 is an organic/inorganic laminate comprising an organic layer and some other inorganic layer. The organic/inorganic laminate may have one or more organic layers and one or more inorganic layers. In this, any of the organic layer or the inorganic layer may be on the side of 302; and any of the organic layer or the inorganic layer may face the outside (may be the boundary to the environment).

Fig. 3 is another embodiment of the environment-sensitive device of the invention. In Fig. 3, 311 is another inorganic layer serving as a passivation layer. 313 is an organic/inorganic aminate. The organic/inorganic laminate in this device comprises at least one silicon hydronitride layer, at least one organic layer and at least one other inorganic layer. Each layer may be plural layers that are laminated. Any of the silicon hydronitride layer, the organic layer and the inorganic layer may be on the side of 311. Any of the silicon hydronitride layer, the organic layer and the inorganic layer may face the outside (may be the boundary to the environment); however, in case where the device has no layer outside 313, it is desirable that at least one inorganic layer is provided on the silicon hydronitride layer facing the outside since the function, or that is, the moisture absorbability of the silicon hydronitride layer may be worsened by the contact of the layer with the outside. Especially in the invention, it is desirable that the silicon hydronitride layer is provided between the environment-sensitive element and the inorganic layer, and this embodiment is characterized in that the silicon hydronitride layer substantially plays a role of desiccant. Accordingly, the invention is significant in that it can give an element substantially equal to a desiccant to any of canned (bottled), solid-sealed or film-sealed environment-sensitive devices. In particular, the invention is extremely significant and meaningful in that its combination with a solid-sealing or film-sealing with a gas-barrier film may bring about manufacture of flexible devices.

### (Silicon Hydronitride Layer)

"Silicon hydronitride layer" in the invention means a layer comprising silicon hydronitride as the main ingredient thereof, and for example, the layer contains silicon hydronitride in an amount of at least 90 % by weight. The silicon hydronitride layer may contain an oxygen atom. However, when the oxygen content is too much, then the moisture absorbability (deoxidation capability) of the layer may lower; and therefore, the oxygen content is preferably at most 50 atomic % of nitrogen in the silicon hydronitride layer.

The silicon hydronitride layer has moisture absorbability (deoxidation capability). In case where the hydrogen content of the layer is low, the moisture absorbability (deoxidation capability) thereof may be low; but on the contrary, when the hydrogen content is too high, then the material stability may be poor. Accordingly, in the invention, the hydrogen/nitrogen ratio in the silicon hydronitride layer is preferably from 1 to 3. For increasing the hydrogen content, for example, the ammonia/silane ratio in the starting gas for the layer may be controlled suitably; and when the ammonia/silane ratio is high, then the hydrogen content of the layer tends to increase.

Preferably, the film density of the silicon hydronitride layer in the invention is from 1.8 to 2. 0 g/cm³. The layer having a film density of at most 2.0 g/cm³ may have an enhanced moisture-absorbing effect.

The preferred thickness of the silicon hydronitride layer varies depending on the site in which the layer is used. In general, the layer thickness is preferably from 5 to 500 nm, more preferably from 10 to 200 nm. In case where the layer is provided adjacent to a passivation layer, its thickness is preferably from 100 to 2000 nm, more preferably from 200 to 1000 nm.

The silicon hydronitride layer may be formed in any method capable of forming the intended layer. Preferred for it are a sputtering method, a vacuum vapor deposition method, an ionic plating method and a plasma CVD method. Concretely, the film formation methods described in Japanese Patent 3400324, and JP-A 2002-322561 and 2002-361774 may be employed herein. More preferred is a PECVD method.

### (Other Inorganic Layer)

In the invention, the barrier laminate has at least one inorganic layer in addition to the silicon hydronitride layer. The inorganic layer is generally a layer of a thin film of a metal compound. For forming the inorganic layer, employable is any method capable of forming the intended thin film. For example, suitable to it are a coating method, a sputtering method, a vacuum vapor deposition method, an ionic plating method and a plasma CVD method. Concretely, the film formation methods described in Japanese Patent 3400324, and JP-A 2002-322561 and 2002-361774 may be employed herein.

The ingredient to constitute the inorganic layer is not specifically defined, and may be any one satisfying the above-mentioned properties. For example, employable are oxides, nitrides, carbides, oxynitrides, oxycarbides, nitrocarbides and oxynitrocarbides containing at least one metal selected from Si, Al, In, Sn, Zn, Ti, Cu, Ce or Ta. Of those, preferred are oxides, nitrides or oxynitrides of a metal selected from Si, Al, In, Sn, Zn or Ti; and more preferred are oxides, nitrides or oxynitrides of Si or Al. These may contain any other element as a secondary ingredient. In the invention, the inorganic layer is preferably a layer of aluminium oxide, silicon oxide, silicon oxynitride or silicon nitride.

In case where the invention is directed to an organic EL device, the inorganic layer therein may be divided into a passivation layer adjacent to the organic EL device and any other inorganic layer. The passivation layer and the other inorganic layer in this case are described below.

### (Passivation Layer)

The passivation layer (protective layer), as a type of the inorganic layer, is disposed adjacent to the environment-sensitive element that is disposed on a substrate. "Adjacent to" as referred to herein means that the two are in direct contact with each other, or means that the two are in contact with each other via any other layer (organic layer, inorganic layer, functional layer or the like) therebetween. The material of the passivation layer includes silicon nitride, silicon oxide, silicon oxynitride and the like; and in the invention, a silicon nitride layer is preferably provided. The film density of the silicon nitride layer is preferably from 2.1 to 2.8 g/cm³. Having the film density falling within the range, the layer may attain a good passivation effect (protective effect). The thickness of the passivation layer is not specifically defined. Preferably, it is within a range of from 100 nm to 10 µm, more preferably from 500 nm to 5 µm.

The passivation layer may comprise one inorganic material or may comprise a mixture of two or more materials. As the case may be, the layer may be a laminate of at least two layers of different materials. As so mentioned in the above, it may be a layer (region) of such that the boundary of the layer to the adjacent organic layer is indefinite and the composition thereof continuously changes in the film thickness direction, as in USP-A 2004-46497.

### (Other Inorganic Layer)

In the invention, an inorganic layer is provided in addition to the passivation layer. As the material of the inorganic layer, preferred are silicon nitride, silicon oxide, silicon oxynitride, silicon oxycarbide, aluminium oxide and the like.

The thickness of the inorganic layer is not specifically defined. In generally, it is preferably within a range of from 5 nm to 500 nm, more preferably from 10 nm to 200 nm.

The inorganic layer may comprise one inorganic material or may comprise a mixture of two or more materials. As the case may be, the layer may be a laminate of at least two layers of different materials. As so mentioned in the above, it may be a layer (region) of such that the boundary of the layer to the adjacent organic layer is indefinite and the composition thereof continuously changes in the film thickness direction, as in USP-A 2004-46497.

In case where the invention is applied to an organic EL device, it is desirable that the passivation layer and the silicon hydronitride layer are adjacent to the environment-sensitive element (organic EL element) continuously in that order, as in Fig. 2. In case where the passivation layer is a silicon nitride layer, the silicon nitride layer and the silicon hydronitride layer may form a composite layer at the boundary therebetween, via which the compositions of the two layers continuously change not forming a definite boundary area between them.

### (Organic Layer)

The organic layer is generally a polymer layer. Concretely, this is a layer of polyester, acrylic resin, methacrylic resin (in this description, acrylic resin and methacrylic resin may be referred to as acrylate polymer, as combined), methacrylic acid/maleic acid copolymer, polystyrene, transparent fluororesin, polyimide, fluoropolyimide, polyamide, polyamidimide, polyetherimide, cellulose acylate, polyurethane, polyether-ether ketone, polycarbonate, alicyclic polyolefin, polyarylate, polyether sulfone, polysulfone, fluorene ring-modified polycarbonate, alicyclic-modified polycarbonate, fluorene ring-modified polyester, acryloyl compound or the like thermoplastic resin, or polysiloxane or any other organic silicon compound. The organic layer may be formed of a single material or a mixture of different materials. Two or more organic layers may be laminated. In this case, the constitutive layers may have the same composition or may have different compositions. As so mentioned in the above, the organic layer may be such that the boundary of the layer to the adjacent inorganic layer is indefinite and the composition thereof continuously changes in the film thickness direction, as in USP-A 2004-46497.

Preferably, the organic layer is smooth and has a high film hardness. Regarding the smoothness of the organic layer, the mean roughness of the layer of 10 µm square (Ra value) is preferably at most 10 nm, more preferably at most 2 nm. Preferably, the organic layer has a film hardness in some degree or more. Regarding the preferred hardness of the layer, concretely, the indentation hardness thereof, as measured according to a nanoindentation method, is preferably at least 100 N/mm², more preferably at least 200 N/mm². The pencil hardness of the layer is preferably at least HB, more preferably at least H.

The thickness of the organic layer is not specifically defined. When too thin, however, the layer could hardly have a uniform thickness; and when too thick, the layer may be cracked by external force and its barrier properties may be thereby worsened. From these viewpoints, the thickness of the organic layer is preferably from 10 nm to 2 µm, more preferably from 100 nm to 1 µm.

For forming the organic layer, for example, employable is an ordinary solution coating method or vacuum film formation method. The solution coating method includes, for example, a dipping method, an air knife coating method, a curtain coating method, a roller coating method, a wire bar coating method, a gravure coating method, a slide coating method, and an extrusion coating method using a hopper described in USP 2681294. The organic layer may be formed by applying a commercially-available polymerizing adhesive and curing it. The vacuum film formation method is not specifically defined. Preferably, the method is for film formation through vapor deposition or plasma CVD. In the invention, a polymer solution may be used in the solution coating method for forming the organic layer; or a hybrid coating method with an inorganic substance-containing material, as in JP-A 2000-323273 and 2004-25732, may also be employed for the organic layer formation. A film of a polymer precursor (e. g. , monomer) may be first formed, and this may be polymerized to give a polymer layer. Preferred examples of the monomer for use in the invention are acrylates and methacrylates, and commercial adhesives. The commercial adhesives include Daizo-Nichimori's Epotec series, Nagase ChemteX's XNR-5000 series, and Three Bond's 3000 series.

Preferred examples of acrylates and methacrylates are, for example, the compounds described in USP 6083628 and 6214422. Some of these are shown below.

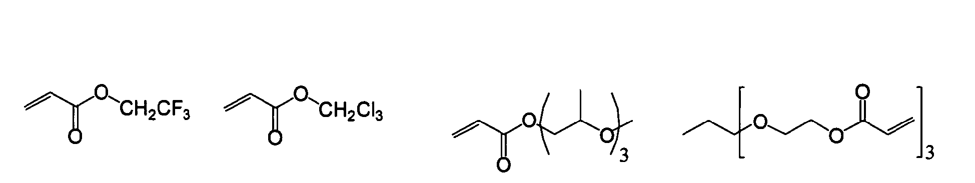

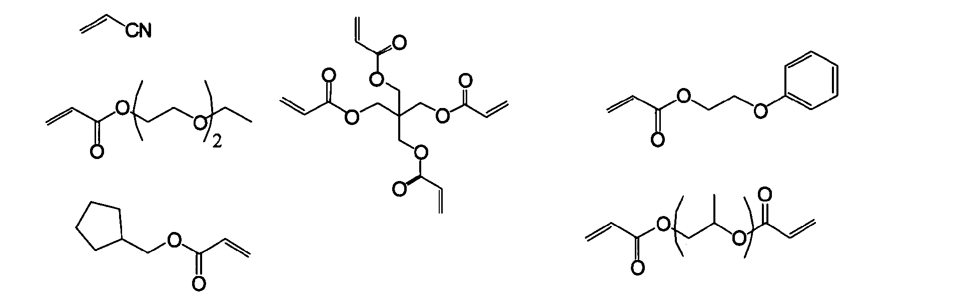

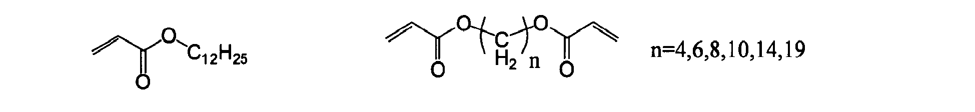

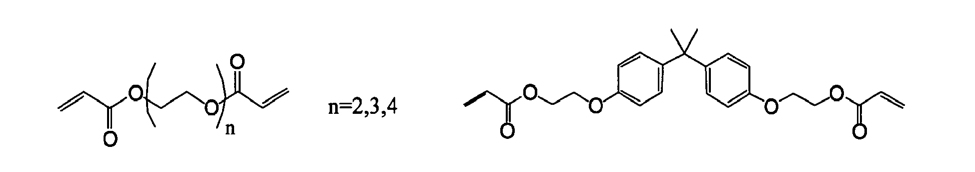

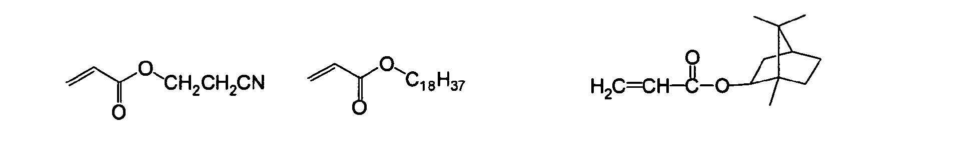

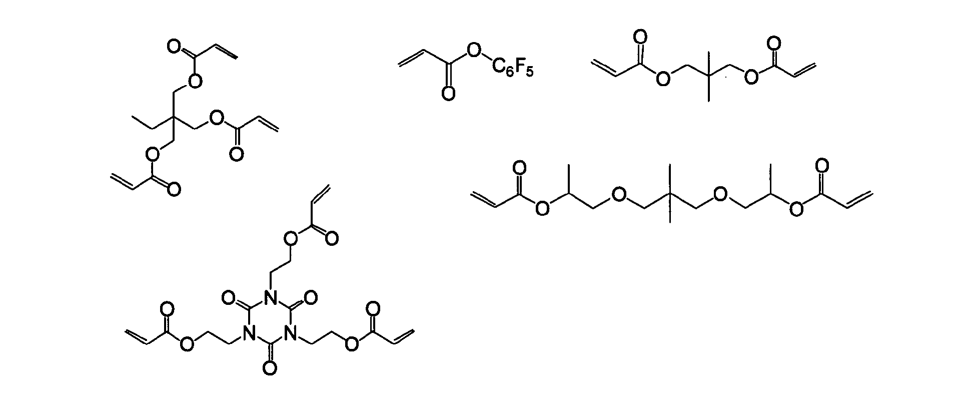

Other exemplified compounds are shown below:

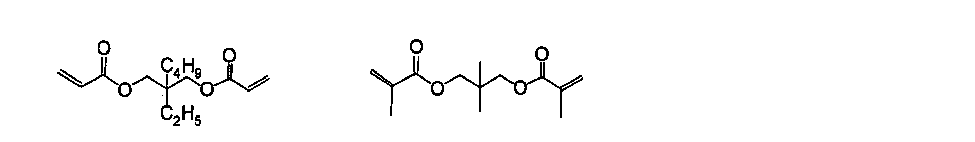

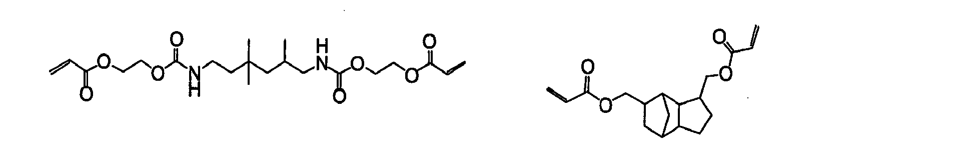

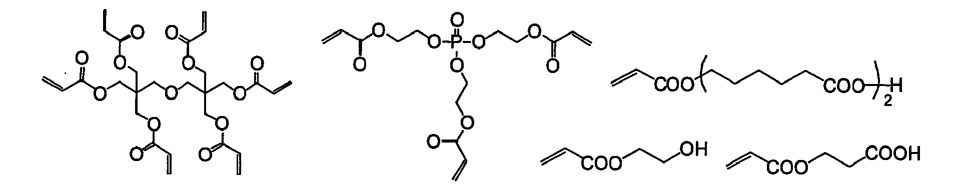

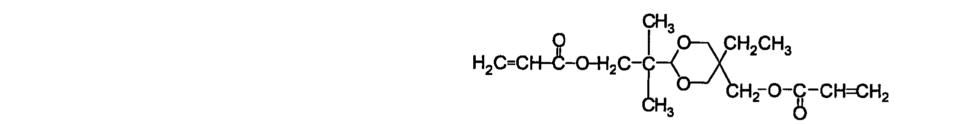

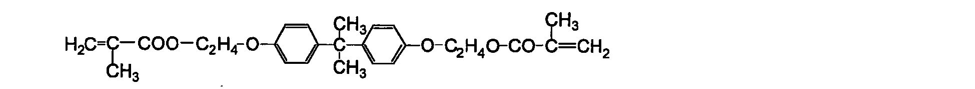

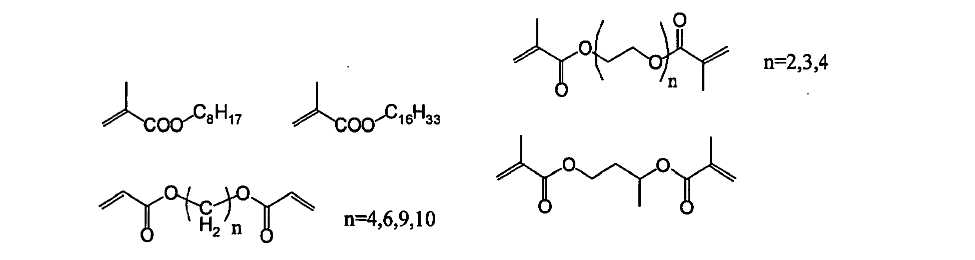

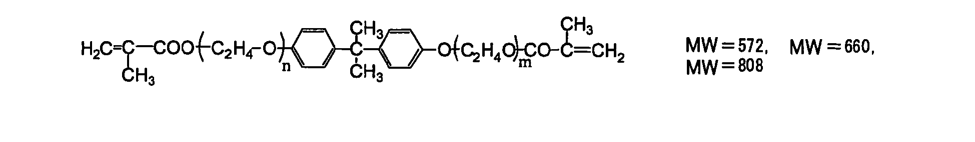

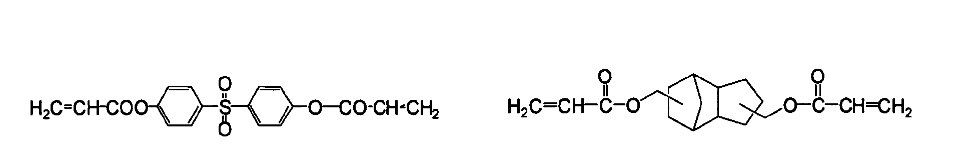

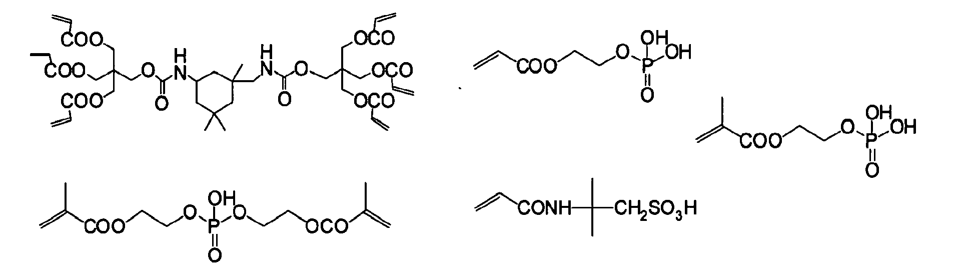

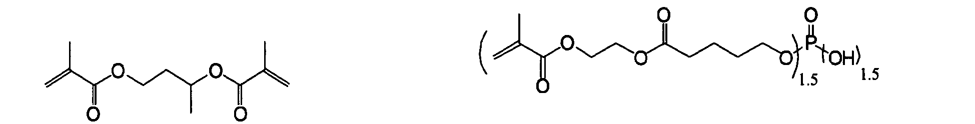

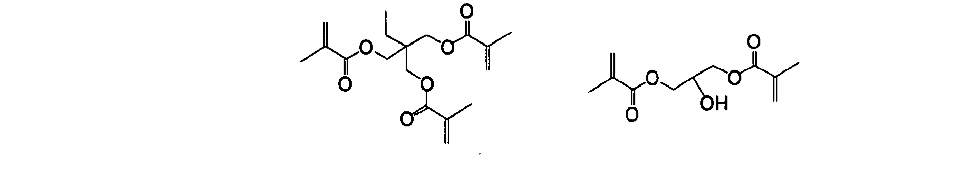

Though the monomer polymerization method is not particularly limited, heat polymerization, photo (ultraviolet ray or visible light) polymerization, electron beam polymerization, plasma polymerization or a combination thereof is preferably employed. In the case where heat polymerization is carried out, the plastic film used as a substrate must be heat resistant to an appropriate extent. The glass transition temperature (Tg) of the plastic film is required to be higher than the heating temperature.

In the case where photopolymerization is carried out, a photopolymerization initiator is used in combination. Examples of the photopolymerization initiator include IRGACURE series (for example, IRGACURE 651, IRGACURE 754, IRGACURE 184, IRGACURE 2959, IRGACURE 907, IRGACURE 369, IRGACURE 379 AND IRGACURE 819), DAROCURE series (for example, DAROCURE TPO and DAROCURE 1173) and QAUNTACURE PDO, all of which are marketed by Ciba Specialty Chemicals; and EZACURE series (for example, EZACURE TZM and EZACURE TZT) which are marketed by Sartomer Company.

The light to be irradiated is usually an ultraviolet ray to be emitted from a high pressure mercury vapor lamp or a low pressure mercury vapor lamp. The irradiation energy is preferably 0.5 J/cm² or more, and more preferably 2 J/cm² or more. Since the acrylate or methacrylate is affected by polymerization inhibition due to oxygen in air, it is preferable to reduce the oxygen concentration or oxygen partial pressure at the time of polymerization. In the case of reducing the oxygen concentration at the time of polymerization by a nitrogen purge method, the oxygen concentration is preferably not more than 2%, and more preferably not more than 0.5%. In the case of reducing the oxygen partial pressure at the time of polymerization by a pressure reducing method, the total pressure is preferably not more than 1,000 Pa, and more preferably not more than 100 Pa. Also, it is especially preferable to carry out ultraviolet ray polymerization upon irradiation with energy of 2 J/cm² or more under a reduced pressure condition of not more than 100 Pa.

The polymerization degree of the monomer is preferably 80% or more, more preferably 85% or more, still more preferably 90% or more. The "polymerization degree" used here means the percentage of reacted polymerizable groups out of all polymerizable groups (acryloyl group and methacryloyl group) in the monomer mixture.

### (Functional Layer)

The environment-sensitive device of the invention may have a functional layer on the barrier laminate or in any other position. The functional layer is described in detail in JP-A 2006-289627, paragraphs 0036 to 0038. Examples of other functional layers than those are a matting agent layer, a protective layer, an antistatic layer, a smoothing layer, an adhesiveness improving layer, a light shielding layer, an antireflection layer, a hard coat layer, a stress relaxing layer, an antifogging layer, an anti-soiling layer, a printable layer, etc.

### (Others)

The environment-sensitive device of the invention may have a transparent substrate such as a resin film, a glass sheet or the like, on the barrier laminate.

### (Substrate)

In general, the environment-sensitive element in the invention is provided on a substrate. As the substrate, widely employable is any type of substrate generally used for environment-sensitive elements. The substrate may be a resin film, or may be a gas-barrier film. The gas-barrier film may be one prepared by providing an organic layer and an inorganic layer on the above-mentioned substrate film; and in addition, the gas-barrier films described in JP-A 2004-136466, 2004-148566, 2005-246716 and 2005-262529 are also favorably usable herein.

Not specifically defined, the thickness of the substrate for use in the invention is preferably from 30 µm to 700 µm, more preferably from 40 µm to 200 µm, even more preferably from 50 µm to 150 µm. In any case, the haze of the substrate is preferably at most 3 %, more preferably at most 2 %, even more preferably at most 1 %; and the whole light transmittance thereof is preferably at least 70 %, more preferably at least 80 %, even more preferably at least 90 %.

### «Environment-Sensitive Element»

The environment-sensitive device of the invention means a device of which the properties change as influenced by the substances existing in the environment, for example, oxygen and moisture therein; and for example, it includes image display element, organic memory, organic cell, and organic solar cell. The image display element in the invention is meant to include circular polarizer, liquid-crystal display element, touch panel, and organic EL device.

### <Circularly polarizing plate>

The circularly polarizing plate can be prepared by stacking laminating a λ/4 plate and a polarizing plate on the substrate of the invention. In that case, the both plates are stackedlaminated in such a manner that a slow axis of the λ/4 plate and an absorption axis of the polarizing plate form 45°. As such a polarizing plate, one stretched in a direction of 45° against the machine direction (MD) thereof is preferably used, and those described in, for example, JP-A-2002-865554 can be favorably used.

### <Liquid crystal display device>

The reflection type liquid crystal display device is configured to include a lower substrate, a reflection electrode, a lower alignment film, a liquid crystal layer, an upper alignment film, a transparent electrode, an upper substrate, a λ/4 plate and a polarizing film in order from the lower side. The substrate of the invention can be used as a lower substrate. In the case of giving a color displaying function to the reflection type liquid crystal display device, it is preferable to further provide a color filter layer between the reflection electrode and the lower alignment film or between the upper alignment film and the transparent electrode.

Also, the transmission type liquid crystal display device is configured to include a backlight, a polarizing plate, a λ/4 plate, a lower transparent electrode, a lower alignment film, a liquid crystal layer, an upper alignment film, an upper transparent electrode, an upper substrate, a λ/4 plate and a polarizing plate in order from the lower side. The substrate of the invention can be used as an upper alignment film, an upper transparent electrode. Also, in the case of giving a color displaying function to the transmission type liquid crystal display device, it is preferable to further provide a color filter layer between the lower transparent electrode and the lower alignment film or between the upper alignment film and the upper transparent electrode.

Though the structure of the liquid crystal layer is not particularly limited, it is preferably of, for example, a TN (twisted nematic) type, an STN (super twisted nematic) type, an HAN (hybrid aligned nematic) type, a VA (vertically alignment) type, an ECB (electrically controlled birefringence) type, an OCB (optically compensated bend) type, a CPA (continuous pinwheel alignment) type or an IPS (in-plane switching) type.

### <Touch panel>

As the touch panel, one obtained by applying the gas barrier film of the invention onto a substrate described in, for example, JP-A-5-127822 or JP-A-2002-48913 can be used.

### <Organic EL device>

An "organic EL device" means an organic electroluminescent device. The organic EL device has a cathode and an anode on a substrate and has an organic compound layer including an organic light-emitting layer between the both electrodes. In view of properties of the light-emitting device, it is preferable that at least one electrode of the anode and the cathode is transparent.

In the invention, an embodiment of the laminate of the organic compound layer is preferably an embodiment in which a hole transport layer, a light-emitting layer and an electron transport layer are laminated in order from the anode side. Furthermore, a charge blocking layer may be provided between the hole transport layer and the light-emitting layer or between the light-emitting layer and the electron transport layer. A hole injection layer may be provided between the anode and the hole transport layer; and an electron injection layer may be provided between the cathode and the electron transport layer. The light-emitting layer may comprise only one layer, or may be divided into a first light-emitting layer, a second light-emitting layer, and a third light-emitting layer, and the like. Each of the layers may be divided into plural secondary layers.

Hereinafter, each element constituting the organic EL device is described in detail.

### (Anode)

In general, the anode may have a function as an electrode capable of supplying a hole into the organic compound layer and is not particularly limited as to its shape, structure and size or the like. The anode can be properly chosen among known electrode materials depending upon the use and purpose of the light-emitting device. As described previously, the anode is usually provided as a transparent anode. The transparent anode is described in detail in New Developments of Transparent Conducting Films, supervised by SAWADA, Yutaka (published by CMC Publishing Co., Ltd., 1999). In the case of using a plastic base material with low heat resistance, a transparent anode obtained through fabrication at a low temperature of not higher than 150 °C using ITO or IZO is preferable.

### (Cathode)

In general, the cathode may have a function as an electrode capable of injecting an electron into the organic compound layer and is not particularly limited as to its shape, structure and size or the like. The cathode can be properly chosen among known electrode materials depending upon the use and purpose of the light-emitting device.

As materials constituting the cathode, for example, metals, alloys, metal oxides, electric conductive materials or mixtures thereof can be exemplified. Specific examples thereof include alkaline earth metals (for example, Mg and Ca) , gold, silver, lead, aluminum, a sodium-potassium alloy, a lithium-aluminum alloy, a magnesium-silver alloy, indium and rare earth metals (for example, ytterbium). Though these materials may be used singly, from the standpoint of making stability and electron injection properties compatible with each other, two or more kinds of these materials can be favorably used in combination.

Of these, the material constituting the cathode is preferably a material composed mainly of aluminum.

The material composed mainly of aluminum refers to aluminum alone or an alloy of aluminum and from 0.01 to 10% by mass of an alkali metal or an alkaline earth metal or a mixture thereof (for example, a lithium-aluminum alloy and a magnesium-aluminum alloy). The cathode material is described in detail in JP-A-2-15595 and JP-A-5-121172. Also, a dielectric layer composed of a fluoride or oxide of an alkali metal or alkaline earth metal or the like may be inserted in a thickness of from 0.1 to 5 nm between the cathode and the organic compound layer. This dielectric layer can be considered as a certain kind of the electron injection layer.

The thickness of the cathode can be properly chosen depending upon the material constituting the cathode and cannot be unequivocally defined. However, the thickness of the cathode is in general from about 10 nm to 5 µm, and preferably from 50 nm to 1 µm.

Also, the cathode may be transparent or opaque. The transparent cathode can be formed by thinly fabricating the cathode material in a thickness of from 1 to 10 nm and further laminating a transparent conductive material such as ITO and IZO thereon.

### (Organic compound layer)

The organic electroluminescent device of the invention has at least one organic compound layer including a light-emitting layer. As described previously, examples of other organic compound layers than the organic light-emitting layer include respective layers such as a hole transport layer, an electron transport layer, a charge blocking layer, a hole injection layer and an electron injection layer.

### ((Organic light-emitting layer))

The organic light-emitting layer is a layer having a function such that at the time of application of an electric field, it receives a hole from the anode, the hole injection layer or the hole transport layer and receives an electron from the cathode, the electron injection layer or the electron transport layer to provide a field of recombination of the hole and the electron, thereby achieving light emission. The light-emitting layer may be constituted of only a light-emitting material or may be configured as a mixed layer of a host material and a light-emitting material. The light-emitting material may be a fluorescent light-emitting material or a phosphorescent light-emitting material; and a dopant may be a single material or a combination of two or more kinds of materials. The host material is preferably a charge transport material. The host material may be a single material or a combination of two or more kinds of materials, and examples thereof include a constitution of a mixture of an electron transporting host material and a hole transporting host material. Furthermore, the light-emitting layer may contain a material which does not have charge transporting properties and does not emit light. Also, the light-emitting layer may be a single layer or may be configured of two or more layers, and the respective layers may emit light in a different luminescent color.

Examples of the fluorescent light-emitting material which can be used in the invention include compounds, for example, benzoxazole derivatives, benzimidazole derivatives, benzothiazole derivatives, styrylbenzene derivatives, polyphenyl derivatives, diphenylbutadiene derivatives, tetraphenylbutadiene derivatives, naphthalimide derivatives, coumarin derivatives, condensed aromatic compounds, perynone derivatives, oxadiazole derivatives, oxazine derivatives, aldazine derivatives, pyralidine derivatives, cyclopentadiene derivatives, bisstyrylanthracene derivatives, quinacridone derivatives, pyrrolopyridine derivatives, thiadiazolopyridine derivatives, cyclopentadiene derivatives, styrylamine derivatives, diketopyrrolopyrrole derivatives, aromatic dimethylidyne derivatives, various metal complexes represented by metal complexes of 8-quinolinol derivatives and pyrromethene derivatives, polymer compounds (for example, polythiophene, polyphenylene and polyphenylenevinylene) and organosilane derivatives.

Examples of the phosphorescent light-emitting material include complexes containing a transition metal atom or a lanthanoid atom.

The transition metal atom is not particularly limited, and preferred examples thereof include ruthenium, rhodium, palladium, tungsten, rhenium, osmium, iridium and platinum, with rhenium, iridium and platinum being more preferable.

Examples of the lanthanoid atom include lanthanum, cerium, praseodymium, neodymium, samarium, europium, gadolinium, terbium, dysprosium, holmium, erbium, thulium, ytterbium and lutetium. Of these lanthanoid atoms, neodymium, europium and gadolinium are preferable.

Examples of a ligand of the complex include ligands described in G. Wilkinson, et al., Comprehensive Coordination Chemistry, published by Pergamon Press, 1987; H. Yersin, Photochemistry and Photophysics of Coordination Compounds, published by Springer-Verlag, 1987; and YAMAMOTO, Akio, Organometallic Chemistry - Principles and Applications, published by Shokabo Publishing Co., Ltd., 1982.

Also, examples of the host material which is contained in the light-emitting layer in the invention include materials as enumerated in the following paragraphs of hole injection layer, hole transport layer, electron injection layer and electron transport layer as well as a material having a carbazole skeleton, a material having a diarylamine skeleton, a material having a pyridine skeleton, a material having a pyrazine skeleton, a material having a triazine skeleton and a material having an arylsilane skeleton.

### ((Hole injection layer and hole transport layer))

The hole injection layer and the hole transport layer are each a layer having a function to receive a hole from the anode or the anode side to transport it into the cathode side. Specifically, the hole injection layer and the hole transport layer are each preferably a layer containing a carbazole derivative, a triazole derivative, an oxazole derivative, an oxadiazole derivative, an imidazole derivative, a polyarylalkane derivative, a pyrazoline derivative, a pyrazolone derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidene based compound, a porphyrin based compound, an organosilane derivative, carbon or the like.

### ((Electron injection layer and electron transport layer))

The electron injection layer and the electron transport layer are each a layer having a function to receive an electron from the cathode or the cathode side to transport it into the anode side. Specifically, the electron injection layer and the electron transport layer are each preferably a layer containing a triazole derivative, an oxazole derivative, an oxadiazole derivative, an imidazole derivative, a fluorenone derivative, an anthraquinodimethane derivative, an anthrone derivative, a diphenylquinone derivative, a thiopyran dioxide derivative, a carbodiimide derivative, a fluorenylidenemethane derivative, a distyrylpyrazine derivative, aromatic ring tetracarboxylic acid anhydrides of naphthalene, perylene, etc., a phthalocyanine derivative, a metal complex of every kind represented by metal complexes of 8-quinolinol derivatives and metal complexes composed of, as a ligand, metal phthalocyanine, benzoxazole or benzothiazole, an organosilane derivative or the like.

### ((Hole blocking layer))

The hole blocking layer is a layer having a function to prevent a phenomenon in which the hole which has been transported into the light-emitting layer from the anode side passes through into the cathode side from occurring. In the invention, the hole blocking layer can be provided as an organic compound layer which is positioned adjacent to the light-emitting layer on the cathode side.

Examples of an organic compound constituting the hole blocking layer include aluminum complexes such as BAlq, triazole derivatives and phenanthroline derivatives such as BCP. Also, a layer having a function to prevent a phenomenon in which the electron which has been transported into the light-emitting layer from the cathode side passes through into the anode side from occurring may be provided on the position adjacent to the light-emitting layer on the anode side. The hole injection layer and hole transport layer may serve this function.

### <TFT display device>

The barrier laminate of the invention can be used as a substrate for image display device of a thin film transistor to produce a TFT. The method described in JP-T 10-512104 and others can be used as a method for producing TFT array. The substrate may also have a color filter for color display. The color filter can be produced by any methods. Photography can be used preferably.

### <Solar Cell>

The barrier laminate of the invention can be used also as a sealing film for solar cell devices. Preferably, the barrier laminate of the invention is used for sealing a solar cell device in such a manner that its adhesive layer is on the side near to the solar cell device. The solar cell devices for which the barrier laminate of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

### «Examples»

The invention is described more concretely with reference to the following Examples. In the following Examples, the material used, its amount and the ratio, the details of the treatment and the treatment process may be suitably modified or changed. Accordingly, the invention should not be limited to these Examples.

### Example 1:

An element having a constitution of glass substrate/organic EL element (triplet emission)/silicon nitride layer (passivation layer)/silicon hydronitride layer/adhesive layer (organic layer)/inorganic layer/organic layer/inorganic layer/organic layer/inorganic layer/organic layer/inorganic layer/organic layer/inorganic layer/PEN film was fabricated.

### <Formation of Organic EL Element>

On an ITO electrode-having glass substrate that had been processed for oxygen plasma treatment, disposed were a hole injection layer, a hole transportation layer, a light emission layer, a hole blocking layer, an electron transportation layer and an electron injection layer in that order; and a cathode was provided by patterning through a shadow mask. The layers were all formed by resistance heating vacuum vapor deposition.

The oxygen plasma condition and the constitution of each layer are mentioned below. Oxygen plasma condition:

O₂ flow rate = 10 sccm; RF power 200 W; treatment time 1 minute.

### Hole injection layer:

4,4',4"-Tris(2-naphthylphenylamino)triphenylamine (abbreviated as 2-TNATA), having a thickness of 140 nm. Hole transportation layer:
N,N'-dinaphthyl-N,N'-diphenyl-[1,1'-biphenyl]-4,4'-di amine (abbreviated as α-NPD), having a thickness of 10 nm. Light emission layer:

Layer of 4,4'-bis(9-carbazolyl)biphenyl (abbreviated as CBP) containing fac-tris(2-phenylpyridinato-N,C2')iridium(III) (abbreviated as Ir(ppy)₃) in an amount of 5 % by mass of CBP, and having a thickness of 20 nm.

### Hole blocking layer:

Bis(2-methyl-8-hydroxyquinolinato)-4-phenylphenolatoa luminium(III) (abbreviated as BAlq), having a thickness of 10 nm.

### Electron transportation layer:

Tris(8-hydroxyquinolinato)aluminium (abbreviated as Alq₃), having a thickness of 20 nm.

### Electron injection layer:

LiF, having a thickness of 1 nm.

### Cathode (upper electrode):

Al, having a thickness of 200 nm. The crossing area of the ITO electrode and the Al electrode (light emission area) is 2 mm x 2 mm.

### <Formation of Silicon Nitride Layer and Silicon Hydronitride Layer>

On the surface of the organic EL element prepared in the above, formed were a silicon nitride layer and a silicon hydronitride layer in that order according to a PECVD method.

The organic EL element was set in a reaction chamber, and a starting gas of PECVD starting gas formulation 1 described below was introduced thereinto under reduced pressure. A high-frequency power of 13.56 MHz was given to it for plasma generation, and a silicon nitride layer (except Si, N ingredient content: 97 mol%) was thereby formed. The film formation time was so controlled that the thickness of the formed film could be 2 µm. The plasma was once stopped, and then another starting gas of PECVD starting gas formulation 2 described below was introduced into the chamber under the same condition as previously, and a silicon hydronitride layer (except Si, N ingredient content: 36 mol%, H ingredient content: 63 mol%) was thereby formed. The film formation time was so controlled that the thickness of the formed film could be 500 nm. (PECVD starting gas formulation 1: for silicon nitride layer) Silane 25 sccm, ammonia 15 sccm, hydrogen 15 sccm, nitrogen 195 sccm.
(PECVD starting gas formulation 2: for silicon hydronitride layer)
Silane 25 sccm, ammonia 50 sccm, nitrogen 175 sccm.

### <Density Measurement>

The density of the layers formed with the formulations 1 and 2 was measured through X-ray diffractiometry. The density was 2.4 g/cm³ (formulation 1), and 1.9 g/cm³ (formulation 2).

### <Composition Determination>

The elementary composition except hydrogen of the layers formed with the formulations 1 and 2 was quantitatively determined through ESCA. The hydrogen content was determined according to a hydrogen front-scattering method.
Si: 48 %, N: 49.5 %, O: 0.5 %, H: 2 % (formulation 1),
Si: 29 %, N: 23 %, O: 1 %, H: 47 % (formulation 2).

### <Gas-Barrier Film>

Using a laminate film formation device, Vitex Systems' Guardian 200 Model, an organic/inorganic laminate gas-barrier film was formed on a commercial PEN film (Q65FA, 100 µm, by Teijin-DuPont). The organic layer was formed by flash vapor deposition followed by UV-polymerization of a UV-curable polymer precursor, Vitex Systems' BRS-0101, thereby to give a layer having a thickness of 1.1 µm. The inorganic layer was an aluminium oxide layer having a thickness of 40 nm, formed by reactive sputtering with an aluminium target.

### <Sealing Step>

A protective layer was formed on the organic EL element, and this was stuck to the gas-barrier film on the side of the organic/inorganic laminate thereof, using a thermosetting adhesive (Daizo-Nichimori's Epotec 310), and the adhesive was cured by heating at 65°C for 3 hours.

### <Evaluation>

The samples produced herein were tested in an aging test, by keeping them in an environment at 40°C and 90 % RH for 500 hours. In Example 1, the samples were compared with a comparative organic EL device that had been produced in the same manner as in Example 1 except that the silicon hydronitride layer was not formed and the thickness of the silicon nitride layer was changed to 2.5 µm, in point of the generation of dark spots. As a result, it was confirmed that the number of dark spots formed in the device of Example 1 was remarkably smaller than that in the comparative device.

### Example 2:

An element having a constitution of glass substrate/organic EL element (triplet emission)/silicon nitride layer/silicon hydronitride layer/organic layer/inorganic layer/organic layer/inorganic layer/organic layer/inorganic layer/organic layer/inorganic layer/organic layer was fabricated.

### <Sealing Step>

In the same manner as in Example 1, an intermediate structure of glass substrate/organic EL element (triplet emission)/silicon nitride layer/silicon hydronitride layer was formed, and then, using an organic/inorganic laminate film formation device, Vitex Systems' Guardian 200 Model, an organic/inorganic laminate (barrier laminate) was formed on it. The organic layer was formed by flash vapor deposition followed by UV-polymerization of a UV-curable polymer precursor, Vitex Systems' BRS-0101, thereby to give a layer having a thickness of 1.0 µm. The inorganic layer was an aluminium oxide layer having a thickness of 40 nm, formed by reactive sputtering with an aluminium target. In this apparatus, both the organic layer and the inorganic layer are formed under reduced pressure, and the film formation chambers for the organic layer and the inorganic layer are connected with each other; and therefore in this, the two layers can be continuously formed under reduced pressure. Accordingly, the structure is not exposed to open air until the formation of the barrier laminate is completed.

The device produced in Example 2 was compared with a comparative organic EL device that had been produced in the same manner as in Example 2 except that the silicon hydronitride layer was not formed and the thickness of the silicon nitride layer was changed to 2. 5 µm, in point of the generation of dark spots according to the same evaluation method as in Example 1. As a result, it was confirmed that the number of dark spots formed in the device of Example 2 was remarkably smaller than that in the comparative device.

### Example 3:

In the same manner as in Example 2 but changing the glass substrate therein to the gas-barrier film formed in Example 1, an element having a constitution of gas-barrier film substrate/organic EL element (triplet emission)/silicon nitride layer/silicon hydronitride layer/organic layer/inorganic layer/organic layer/inorganic layer/organic layer/inorganic layer/organic layer/inorganic layer/organic layer was fabricated. The organic EL device was disposed on the side of the organic/inorganic laminate of the gas-barrier film.

The device produced in Example 3 was compared with a comparative organic EL device that had been produced in the same manner as in Example 3 except that the silicon hydronitride layer was not formed and the thickness of the silicon nitride layer was changed to 2.5 µm, in point of the generation of dark spots according to the same evaluation method as in Example 1. As a result, it was confirmed that the number of dark spots formed in the device of Example 3 was remarkably smaller than that in the comparative device.

### Example 4:

An element having a constitution of glass substrate/organic EL element (triplet emission)/silicon nitride layer (thickness, 2.5 µm)/organic layer/inorganic layer/organic layer/inorganic layer/silicon hydronitride layer/inorganic layer/organic layer/inorganic layer/organic layer was fabricated.

In the same manner as in Example 2, an intermediate structure of glass substrate/organic EL element (triplet emission)/silicon nitride layer (thickness, 2.5 µm)/organic layer/inorganic layer/organic layer was formed; and then, on it, a silicon nitride layer having a thickness of 50 nm was formed according to the PECVD method (gas formulation 1) in Example 1, a silicon hydronitride layer having a thickness of 50 nm was formed according to the PECVD method (gas formulation 2) in Example 1, and a silicon nitride layer having a thickness of 50 nm was formed according to the PECVD method (gas formulation 1) in Example 1, in that order. Further on it, a laminate of organic layer/inorganic layer/organic layer was disposed in the same manner as in Example 2.

The device produced in Example 4 was compared with a comparative organic EL device that had been produced in the same manner as in Example 4 except that the silicon hydronitride layer was not formed and the thickness of the silicon nitride layer was changed to 50 nm (or that is, the upper and lower silicon nitride layers form an inorganic layer having a thickness of 150 nm, as combined), in point of the generation of dark spots according to the same evaluation method as in Example 1. As a result, it was confirmed that the number of dark spots formed in the device of Example 4 was remarkably smaller than that in the comparative device.

## Claims

1. An environment-sensitive device comprising an environment-sensitive element and a barrier laminate in that order on a substrate, wherein the barrier laminate comprises at least one silicon hydronitride layer and at least one other inorganic layer.

2. The environment-sensitive device according to claim 1, wherein the barrier laminate further comprises at least one organic layer.

3. The environment-sensitive device according to claim 2, wherein at least one of the organic layer comprises an acrylate polymer as the main ingredient thereof.

4. The environment-sensitive device according to any one of claims 1 to 3, wherein at least one of the other inorganic layer is a passivation layer.

5. The environment-sensitive device according to any one of claims 1 to 4, wherein at least one of the other inorganic layer is a silicon nitride layer.

6. The environment-sensitive device according to claim 5, wherein the silicon nitride layer is provided on the side of the environment-sensitive element of the silicon hydronitride layer.

7. The environment-sensitive device according to claim 5 or 6, wherein the silicon nitride layer is formed by a PECVD method.

8. The environment-sensitive device according to any one of claims 1 to 7, wherein the hydrogen/nitrogen ratio in the silicon hydronitride layer is from 1 to 3.

9. The environment-sensitive device according to any one of claims 1 to 8, wherein the silicon hydronitride layer has a film density of from 1.8 to 2.0 g/cm³.

10. The environment-sensitive device according to any one of claims 1 to 9, wherein the substrate is a flexible substrate.

11. The environment-sensitive device according to any one of claims 1 to 10, wherein at least one of the other inorganic layer comprises aluminium oxide as the main ingredient thereof.

12. The environment-sensitive device according to any one of claims 1 to 11, wherein the substrate is a gas-barrier film.

13. The environment-sensitive device according to any one of claims 1 to 12, which is an organic EL device.

14. A method of sealing an environment-sensitive element, which comprises providing a barrier laminate comprising at least one silicon hydronitride layer and at least one other inorganic layer, on the environment-sensitive element provided on a substrate.

15. A method for producing an environment-sensitive device, which comprises providing a barrier laminate comprising at least one silicon hydronitride layer and at least one other inorganic layer, on an environment-sensitive element provided on a substrate.
